# EUROPEAN PATENT APPLICATION

(11) **EP 4 779 435 A1**
(43) Date of publication of application: **22.07.2026**
(21) Application number: 25764398.1
(22) Date of filing: 26.08.2025
(51) Int. Cl.: G06F 1/18, G06F 1/16, H05K 9/00, H04M 1/02

(54) **ELECTRONIC DEVICE INCLUDING DISPLAY INCLUDING GROUNDED PLATE**

(30) Priority: 28.11.2024 KR 20240174190; 26.12.2024 KR 20240197709
(71) Applicant: Samsung Electronics Co., Ltd, Suwon-si, Gyeonggi-do 16677 (KR)
(72) Inventor: JUNG, Hyunsuk, Suwon-si, Gyeonggi-do 16677 (KR); LEE, Soyoung, Suwon-si, Gyeonggi-do 16677 (KR); LEE, Wonho, Suwon-si, Gyeonggi-do 16677 (KR); JUNG, Hojin, Suwon-si, Gyeonggi-do 16677 (KR)
(74) Representative: Gulde & Partner
(86) International application number: PCT/KR2025/013004
(87) International publication number: WO 2026/116694

(57) **Abstract**

An electronic device includes a printed circuit board, PCB, and a display. The display includes a display panel including a front portion, a rear portion, and a connection portion, display driver integrated circuitry, DDI, attached to the rear portion of the display panel, a plate, disposed between the front portion of the display panel and the rear portion of the display panel, a conductive adhesive, including a first side attached to another portion of the rear portion of the display panel and a second side opposite to the first side, electrically connected to the plate, and a flexible PCB, FPCB, electrically connected to the conductive adhesive, electrically connected to the rear portion of the display panel and the PCB to electrically connect the DDI and the PCB.

## Description

### [Technical Field]

The present disclosure relates to an electronic device including a display including a grounded plate.

### [Background Art]

An electronic device may include a display for displaying visual information. The display may be controlled through display driver integrated circuitry (DDI). The DDI may be electrically connected to a rear portion (e.g., a rear panel) of a display panel. The DDI may display the visual information through the display by controlling a plurality of sub-pixels included in a front portion (e.g., a front panel) of the display panel. The rear portion of the display panel may be non-conductive. The display may include a plate for supporting the display panel. The plate may be formed from a metallic material for rigidity.

The above-described information may be provided as a related art for the purpose of helping understanding of the present disclosure. No argument or decision is made as to whether any of the above description may be applied as a prior art related to the present disclosure.

### [Disclosure]

### [Technical Solution]

An electronic device is disclosed. The electronic device includes a printed circuit board (PCB) including a ground layer. The electronic device comprises a display. The display includes a display panel including a front portion including a plurality of sub pixels, a rear portion opposite to the front portion of the display panel, and a connection portion, extending from the front portion of the display panel to the rear portion of the display panel, that is bent. The display includes a display driver integrated circuitry (DDI) attached to a portion of the rear portion of the display panel. The display may include a plate, disposed between the front portion of the display panel and the rear portion of the display panel, supporting the front portion of the display panel. The display includes a conductive adhesive, including a first side attached to another portion of the rear portion of the display panel and a second side opposite to the first side, electrically connected to the plate. The display includes a flexible PCB (FPCB), electrically connected to the conductive adhesive, electrically connected to the rear portion of the display panel and the PCB to electrically connect the DDI and the PCB.

An electronic device is disclosed. The electronic device includes a housing defining an exterior of the electronic device. The electronic device comprises a bracket, disposed in the housing, corresponding to a ground of the electronic device. The electronic device comprises a printed circuit board (PCB), disposed in the housing, including a ground layer electrically connected to the bracket. The electronic device comprises a display. The display includes a display panel including a front portion including a plurality of sub pixels, a rear portion, opposite to the front portion of the display panel, disposed in the housing, and a connection portion, extending from the front portion of the display panel to the rear portion of the display panel. The display includes a display driver integrated circuitry (DDI) connected to the rear portion of the display panel. The display includes a plate, disposed between the front portion of the display panel and the rear portion of the display panel, supporting the front portion of the display panel. The display includes a conductive adhesive, including a first side attached to the rear portion of the display panel and a second side opposite to the first side. The display includes a flexible PCB (FPCB), electrically connected to the conductive adhesive, electrically connected to the rear portion of the display panel and the PCB, respectively, to electrically connect the DDI and the PCB. The display includes a shielding sheet, covering the FPCB, contacted with the second side of the conductive adhesive and the plate. The plate is grounded by the shielding sheet contacted with the plate, the conductive adhesive contacted with the shielding sheet, the FPCB electrically connected to the second side of the conductive adhesive, and the PCB electrically connected to the FPCB.

### [Description of the Drawings]

FIG. 1 is a block diagram of an electronic device in a network environment according to various embodiments.
FIG. 2A illustrates an example of an unfolded state of an electronic device according to an embodiment.
FIG. 2B illustrates an example of a folded state of an electronic device according to an embodiment.
FIG. 2C is an exploded view of an electronic device according to an embodiment.
FIG. 3 is a block diagram of an electronic device according to an embodiment.
FIG. 4 is a perspective view of a display according to an embodiment.
FIG. 5 is a cross-sectional view of the display of FIG. 4 cut along line A-A'.
FIG. 6 illustrates a portion of a rear side of a display panel.
FIG. 7 illustrates a state in which a conductive adhesive is attached to the display of FIG. 6.
FIG. 8 illustrates a state in which a flexible printed circuit board is disposed on the display of FIG. 7.
FIG. 9 illustrates a portion of a rear side of a display panel to which a conductive adhesive is attached.
FIG. 10 illustrates a state in which a flexible printed circuit board is disposed on the display of FIG. 9.
FIG. 11 illustrates a state in which a shielding sheet is disposed on the display of FIG. 10.
FIG. 12 illustrates a rear side of a display to which a waterproof tape is attached.
FIG. 13 illustrates an electronic device according to a comparative example.
FIG. 14 illustrates an electronic device according to an embodiment.
FIG. 15 illustrates an electronic device according to an embodiment.
FIG. 16 illustrates an example of a rear side of the display of FIG. 15.
FIG. 17 illustrates another example of a rear side of the display of FIG. 15.
FIG. 18 is a block diagram of a display module according to various embodiments.

### [Mode for Invention]

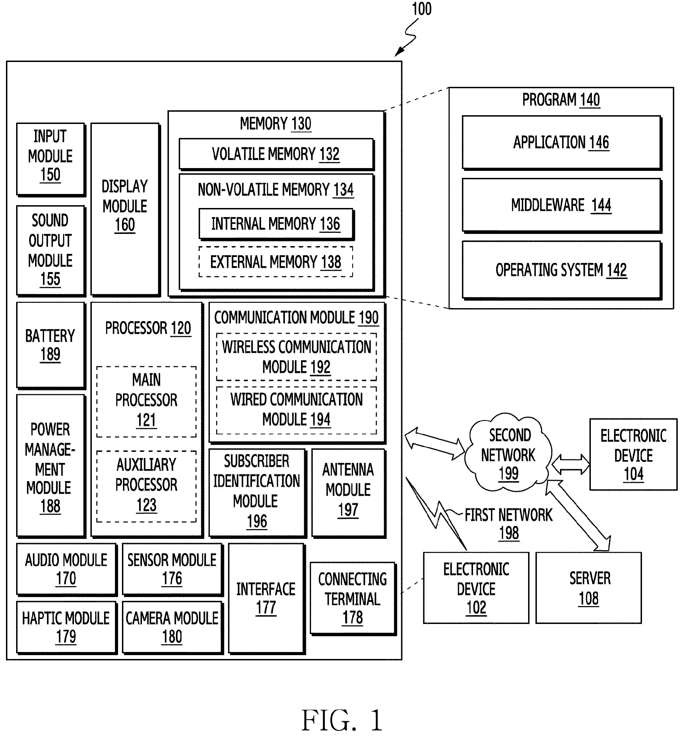

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160). In some embodiments, at least one of the components may be omitted from the electronic device 101.

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface. Other types of interfaces known to those skilled in the art are likewise possible.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector). Other types of connecting terminals known to those skilled in the art are likewise possible.

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC), wherein the disclosure is not limited to such implementation.

The battery 189 may supply power to at least one component of the electronic device 101. According to an embodiment, the battery 189 may include, for example, a primary cell which is not rechargeable, a secondary cell which is rechargeable, or a fuel cell. Alternatively or additionally, the electronic device 101 may comprise means for wirelessly receiving power to charge the same, i.e. a wireless charging module.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

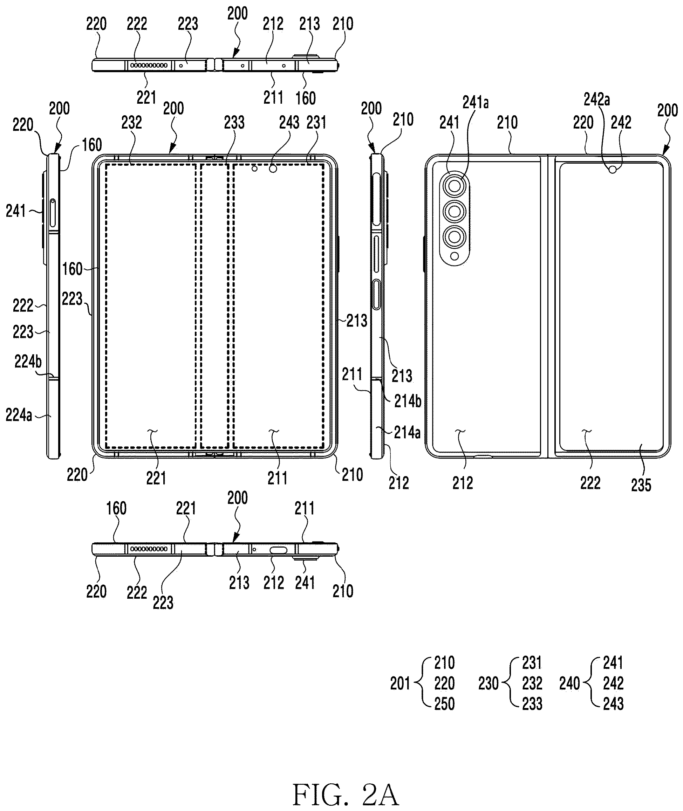

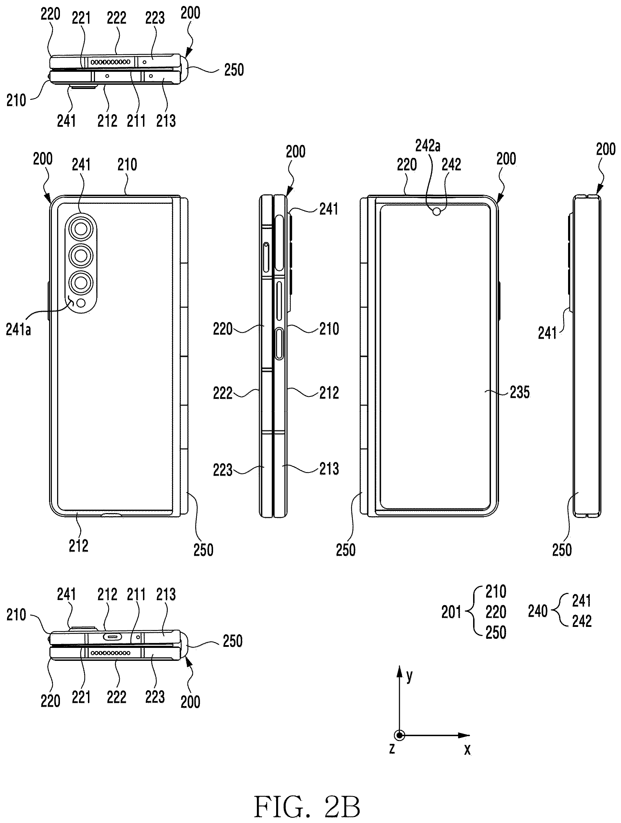

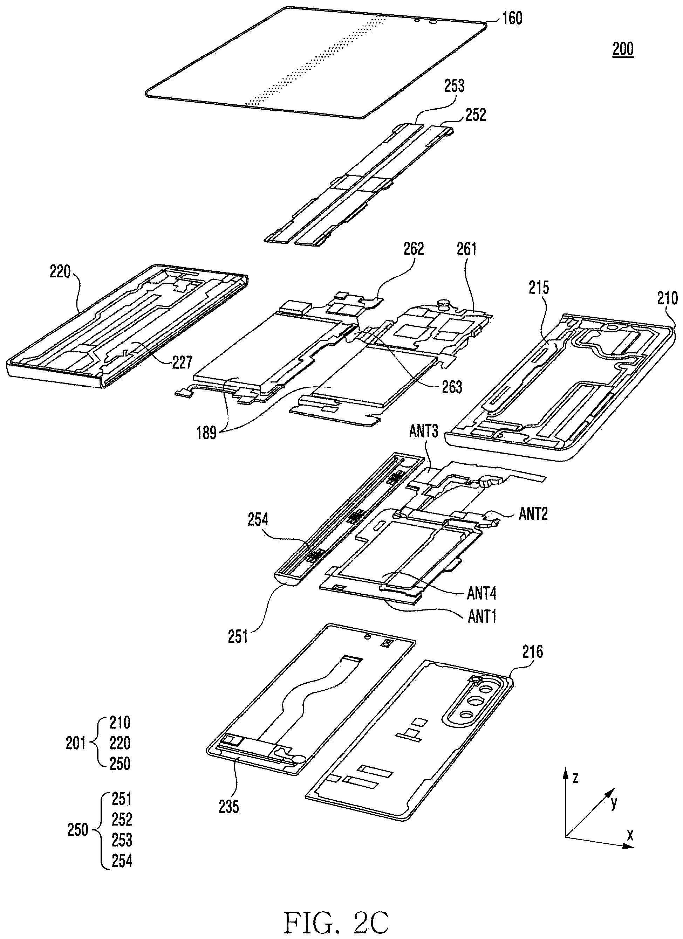

FIG. 2A illustrates an example of an unfolded state of an electronic device according to an embodiment. FIG. 2B illustrates an example of a folded state of an electronic device according to an embodiment. FIG. 2C is an exploded view of an electronic device according to an embodiment.

The electronic device 101 of FIG. 1 may include an electronic device 200 having a foldable structure. Referring to FIGS. 2A, 2B, and 2C, the electronic device 200 according to an embodiment may include a foldable housing 201, a display (e.g., the display module 160 of FIG. 1), one or more cameras 240, and a hinge assembly 250.

According to an embodiment, the foldable housing 201 may define an exterior surface of the electronic device 200. For example, the foldable housing 201, which is a physical exterior surface of the electronic device 200 exposed to the outside, may accommodate components disposed inside the electronic device 200. At least some of components for implementing a function of the electronic device 200 may be disposed in the foldable housing 201. According to an embodiment, the foldable housing 201 may include a first housing part 210 and a second housing part 220.

According to an embodiment, the first housing part 210 may include a first surface 211, a second surface 212 opposite to the first surface 211, and a first side exterior surface 213 at least partially surrounding a periphery of the first surface 211 and a periphery of the second surface 212. For example, the first surface 211 may be referred to as a front exterior surface of the first housing part 210, and the second surface 212 may be referred to as a rear exterior surface of the first housing part 210. The first side exterior surface 213 may be connected to the periphery of the first surface 211 and the periphery of the second surface 212. The first surface 211, the second surface 212, and the first side exterior surface 213 may form an inner space of the first housing part 210. For example, at least one component may be disposed in a space surrounded by the first surface 211, the second surface 212, and the first side exterior surface 213.

According to an embodiment, the second housing part 220 may include a third surface 221, a fourth surface 222 opposite to the third surface 221, and a second side exterior surface 223 at least partially surrounding a periphery of the third surface 221 and a periphery of the fourth surface 222. For example, the third surface 221 may be referred to a front exterior surface of the second housing part 220, and the fourth surface 222 may be referred to a rear exterior surface of the second housing part 220. The second side exterior surface 223 may be connected to the periphery of the third surface 221 and the periphery of the fourth surface 222. The third surface 221, the fourth surface 222, and the second side exterior surface 223 may form an inner space of the second housing part 220. For example, at least one component may be disposed in a space surrounded by the third surface 221, the fourth surface 222, and the second side exterior surface 223.

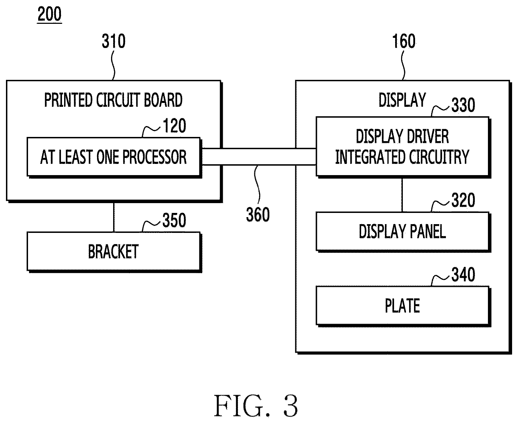

According to an embodiment, the display 160 may correspond to a flexible display. The display 160 may include a display panel (e.g., a display panel 320 of FIG. 3) configured to display visual information. The display panel 320 may include a front portion 230 including a plurality of pixels. Each of the plurality of pixels may include a plurality of sub-pixels. In terms of displaying the visual information, the front portion 230 of the display panel 320 may be referred to as a display region or an active region. The front portion 230 of the display panel 320 may be referred to as a front panel. The front portion 230 may be covered by a substantially transparent window and/or protection layers.

According to an embodiment, the front portion 230 of the display panel 320 may include a first portion 231, a second portion 232, and a third portion 233 disposed between the first portion 231 and the second portion 232. The electronic device 200 may further include a cover display 235 distinguished from the display 160. The cover display 235 may be referred to as a sub-display.

According to an embodiment, the first portion 231 of the front portion 230 of the display panel 320 may correspond to the first housing part 210. The second portion 232 of the front portion 230 of the display panel 320 may be supported by the second housing part 220. At least a portion of the first portion 231 corresponding to the first housing part 210 may be supported by the first housing part 210. At least a portion of the second portion 232 corresponding to the second housing part 220 may be supported by the second housing part 220. The first portion 231 of the front portion 230 and the second portion 232 of the front portion 230 may be substantially flat independently of a state of the electronic device 200.

According to an embodiment, the third portion 233 of the front portion 230 of the display panel 320 may be configured to be at least partially bent based on a rotation of the first housing part 210 and/or a rotation of the second housing part 220. For example, the third portion 233 may be substantially flat in an unfolded state in which the first housing part 210 and the second housing part 220 are unfolded. The third portion 233 may be at least partially bent in a folded state in which the first housing part 210 and the second housing part 220 are folded, or an intermediate state between the folded state and the unfolded state. The display 160 may be a flexible display including the bent third portion 233.

According to an embodiment, the one or more cameras 240 may be configured to obtain an image or a video based on receiving light from a subject outside the electronic device 200. For example, the one or more cameras 240 may include first cameras 241, a second camera 242, and/or a third camera 243. For example, the first cameras 241 may be disposed in the first housing part 210. For example, when the electronic device 200 is viewed from above, the first housing part 210 may include at least one opening 241a overlapping the first cameras 241. The first cameras 241 may obtain an image based on receiving light from the outside of the electronic device 200 through the at least one opening 241a. The first cameras 241 may face a rear side of the electronic device 200.

According to an embodiment, the second camera 242 may be disposed in the second housing part 220. The second housing part 220 may include at least one opening 242a overlapping the second camera 242 when the electronic device 200 is viewed from above. The second camera 242 may obtain an image based on receiving light from the outside of the electronic device 200 through the at least one opening 242a.

According to an embodiment, the third camera 243 may be disposed in the first housing part 210. For example, the first portion 231 of the front portion 230 may include at least one opening overlapping the third camera 243 when the display 160 is viewed from above. The third camera 243 may obtain an image based on receiving light from the outside of the display 160 through the at least one opening.

According to an embodiment, the second camera 242 and the third camera 243 may be disposed below (e.g., a -z direction) the display 160 or the cover display 235. For example, the second camera 242 and/or the third camera 243 may include an under display camera (UDC) and/or a punch hole camera.

According to an embodiment, the first housing part 210 and the second housing part 220 may be rotatably coupled. For example, the second housing part 220 may be rotatably coupled to the first housing part 210 through the hinge assembly 250.

According to an embodiment, the hinge assembly 250 may rotatably connect the first housing part 210 and the second housing part 220. The hinge assembly 250 may be disposed between the first housing part 210 and the second housing part 220 of the electronic device 200 so that the electronic device 200 may be folded. The hinge assembly 250 may change the electronic device 200 from the unfolded state to the folded state. The hinge assembly 250 may change the electronic device 200 from the folded state to the unfolded state. For example, the hinge assembly 250 may maintain the electronic device 200 in the intermediate state between the unfolded state and the folded state.

According to an embodiment, the unfolded state may be referred to as a state in which a first direction in which the first portion 231 faces and a second direction in which the second portion 232 faces are substantially the same. The folded state may be referred to as a state in which the first direction is substantially opposite to the second direction. When the electronic device 200 is in the folded state, the first housing part 210 and the second housing part 220 may be stacked or overlapped.

According to an embodiment, when the electronic device 200 is in the folded state and the intermediate state, the first direction and the second direction may be different from each other. When the electronic device 200 is in the folded state, the first direction and the second direction may be opposite to each other. For example, when the electronic device 200 is in the intermediate state, the first direction may form an angle with respect to the second direction.

For example, the electronic device 200 may include at least one conductive portion 214a, and 224a and at least one non-conductive portion 214b and 224b, included in the first side exterior surface 213 and/or the third side exterior surface 223. For example, the at least one conductive portion 214a and 224a may be separated from another conductive portion in the first side exterior surface 213 and/or the third side exterior surface 223b by contacting the at least one non-conductive portion 214b and 224b. In an embodiment, the at least one conductive portion 214a and 224a may operate as an antenna radiator to be used for communication with an external electronic device.

Referring to FIG. 2C, the hinge assembly 250 may be at least partially surrounded by a hinge cover 251. The hinge assembly 250 may include a first hinge plate 252, a second hinge plate 253, and a plurality of hinge modules 254. The hinge cover 251 may at least partially surround components of the hinge assembly 250 and protect the components of the hinge assembly 250. When the electronic device 200 is in the folded state, the hinge cover 251 may be at least partially exposed to the outside of the electronic device 200 through a space between the first housing part 210 and the second housing part 220. When the electronic device 200 is in the unfolded state, the hinge cover 251 may be covered by the first housing part 210 and the second housing part 220. The hinge cover 251 may be referred to as a hinge housing.

According to an embodiment, the first hinge plate 252 and the second hinge plate 253 may rotatably connect the first housing part 210 and the second housing part 220 by being operatively coupled to the first housing part 210 and the second housing part 220, respectively. For example, the first hinge plate 252 may be coupled to a first bracket 215 of the first housing part 210, and the second hinge plate 253 may be coupled to a second bracket 227 of the second housing part 220. As the first hinge plate 252 and the second hinge plate 253 are operatively coupled to the first bracket 215 and the second bracket 227, respectively, the first housing part 210 and the second housing part 220 may be rotatable according to a rotation of the first hinge plate 252 and the second hinge plate 253.

According to an embodiment, the plurality of hinge modules 254 may rotate the first hinge plate 252 and the second hinge plate 253. For example, the plurality of hinge modules 254 may include gears that may be rotatable by being engaged with each other. The first hinge plate 252 and the second hinge plate 253 may be rotated based on a rotation operation of the gears of the plurality of hinge modules 254.

According to an embodiment, the first housing part 210 may include the first bracket 215 and a rear cover 216. The first bracket 215 may be disposed inside the first housing part 210 and may support at least one component disposed in the first housing part 210. The rear cover 216 may at least partially form the second surface 212 of the first housing part 210. For example, the second housing part 220 may include the second bracket 227. The second bracket 227 may be disposed inside the second housing part 220 and may support at least one component disposed in the second housing part 220. For example, the cover display 235 may be disposed below (e.g., the -z direction) the second bracket 227.

The electronic device 200 according to an embodiment may include a plurality of electronic components for implementing various functions in addition to the one or more cameras 240 described above. For example, the electronic device 200 may include a first printed circuit board 261, a second printed circuit board 262, a flexible printed circuit board 263, and/or a battery 189. The above-described electronic components are merely exemplary and are not limited thereto.

For example, the first printed circuit board 261 and the second printed circuit board 262 may respectively provide an electrical connection of components in the electronic device 200. For example, the first printed circuit board 261 may be disposed in the first housing part 210, and the second printed circuit board 262 may be disposed in the second housing part 220. The first printed circuit board 261 may provide an electrical connection between electronic components disposed in the first housing part 210. The second printed circuit board 262 may provide an electrical connection between electronic components disposed in the second housing part 220. The flexible printed circuit board 263 may electrically connect the first printed circuit board 261 and the second printed circuit board 262. For example, the flexible printed circuit board 263 may extend from the first printed circuit board 261 to the second printed circuit board 262 across the hinge assembly 250. For example, the flexible printed circuit board 263 may at least partially overlap the hinge assembly 250.

According to an embodiment, the battery 189, which is a device for supplying power to at least one component of the electronic device 200, may include, for example, a non-rechargeable primary battery and/or a rechargeable secondary battery.

According to an embodiment, the electronic device 200 may include a plurality of antennas ANT1, ANT2, ANT3, or ANT4 to be used for communication with the external electronic device. For example, the electronic device 200 may include the main antenna ANT1, the sub-antenna ANT2, the ultra-wide band (UWB) antenna ANT3, and/or the antenna ANT4 for short-range wireless communication. However, it is not limited thereto. For example, the main antenna ANT1 may include one or more conductive portions forming at least a portion of the first housing part 210 or the second housing part 220. For example, the main antenna ANT1 may include a plurality of conductive portions forming a periphery portion of the first housing part 210. For example, the main antenna ANT1 may further include conductive portions forming an upper periphery or a side periphery of the first housing part 210. The main antenna ANT1 may be configured to transmit and/or receive signals in various frequency bands thorough each of the plurality of conductive portions or a combination of the plurality of conductive portions.

FIG. 3 is a block diagram of an electronic device according to an embodiment.

Referring to FIG. 3, an electronic device 200 may include a printed circuit board 310, at least one processor 120, and a display 160. As described above, the display 160 may be a flexible display configured to be at least partially bent according to a rotation of a first housing part (e.g., the first housing part 210 of FIG. 2A) and a rotation of the second housing part (e.g., the second housing part 220 of FIG. 2A). The display 160 may include a display panel 320, display driver integrated circuitry 330, and a plate 340. The printed circuit board 310 and the display driver integrated circuitry 330 may be disposed in the first housing part 210.

According to an embodiment, the printed circuit board 310 may include a plurality of conductive layers and a plurality of non-conductive layers alternately laminated with the plurality of conductive layers. The printed circuit board 310 may provide an electrical connection of electronic components using wiring and a conductive via, formed by the conductive layers. The printed circuit board 310 may include a ground layer electrically connected to a bracket 350 functioning as a ground of the electronic device 200. The printed circuit board 310 may correspond to the first printed circuit board (the first printed circuit board 261 of FIG. 2C) of FIG. 2C disposed in a first housing part (e.g., the first housing part 210 of FIG. 2A). The bracket 350 of FIG. 3 may correspond to a first bracket (e.g., the first bracket 215 of FIG. 2C) disposed in the first housing part 210. However, it is not limited thereto.

According to an embodiment, the at least one processor 120 may be disposed on the printed circuit board 310. The at least one processor 120 may be used to generate an image to be displayed on the display panel 320. For example, the at least one processor 120 may be configured to provide the image to the display driver integrated circuitry 330. The at least one processor 120 may correspond to the processor (e.g., the processor 120 of FIG. 1) of FIG. 1.

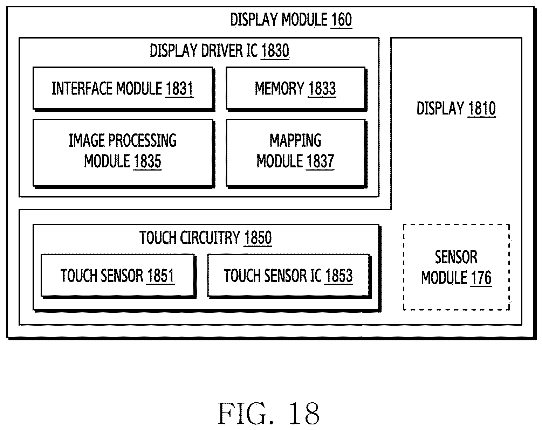

According to an embodiment, the display panel 320 may include pixels including a plurality of sub-pixels. For example, each of the plurality of sub-pixels may include a light emitting diode (e.g., OLED) and a driving transistor (or a driving transistor to drive the light emitting diode) to provide a current to the light emitting diode. The driving transistor may be used to obtain the current provided to the light emitting diode. For example, each of the sub-pixels may include an operation control transistor that includes a drain (or a drain terminal) connected to a source (or a source terminal) of the driving transistor and a source (or a source terminal) connected to a driving voltage line that transmits a driving voltage (VDD). Each of the sub-pixels may include a light emitting control transistor including a source connected to a drain of the driving transistor and a drain connected to an anode of the light emitting diode. For example, the display driver integrated circuitry 330 may provide a light emitting signal for transferring the current to the light emitting diode, to a gate of each of the operation control transistor and the light emitting control transistor. When the light emitting signal is provided to the operation control transistor and the light emitting control transistor, the current may be provided to the light emitting diode. The light emitting diode may emit light based on the current. For example, the display panel 320 may include at least a portion of a display 1810 of FIG. 18 or may correspond to at least a portion of a display 1810 of FIG. 18.

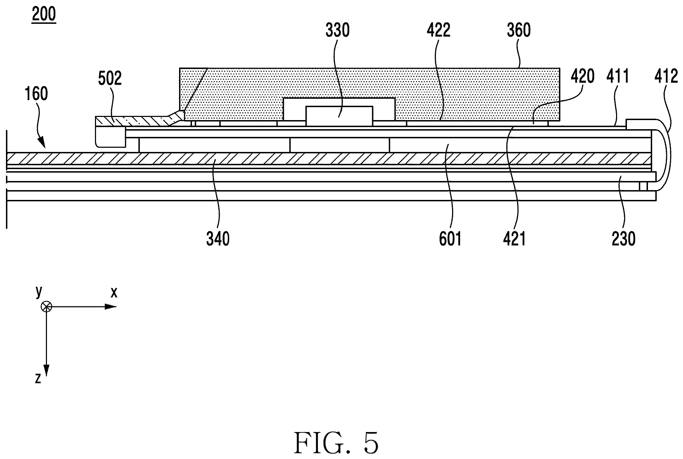

According to an embodiment, the display driver integrated circuitry 330 may be configured to control the display 160. For example, the display driver integrated circuitry 330 may be used to display the image obtained from the at least one processor 120 on the display panel 320. For example, the display driver integrated circuitry 330 may include at least a portion of display driver integrated circuitry (DDI) 1830 of FIG. 18 or may correspond to the at least a portion of the DDI. The display driver integrated circuitry 330 may be electrically connected to the display panel 320 to control the plurality of sub-pixels included in the display panel 320. For example, the display driver integrated circuitry 330 may be electrically connected to the display panel 320 through an anisotropic conductive film (ACF) (e.g., ACF 502 of FIG. 5).

According to an embodiment, the display driver integrated circuitry 330 may be electrically connected to the at least one processor 120. For example, the electronic device 200 may include a flexible printed circuit board 360 connected to each of the display driver integrated circuitry 330 and the at least one processor 120. The flexible printed circuit board 360 may be electrically connected to the display driver integrated circuitry 330 and the printed circuit board 310. For example, the flexible printed circuit board 360 may be connected to each of the display panel 320 electrically connected to the display driver integrated circuitry 330 and the printed circuit board 310 on which the at least one processor 120 is disposed. The display driver integrated circuitry 330 may be electrically connected to the at least one processor 120 disposed on the printed circuit board 310 through the printed circuit board 310 and the flexible printed circuit board 360. For example, a signal or data provided from the at least one processor 120 to the display driver integrated circuitry 330 may be provided through the printed circuit board 310 and the flexible printed circuit board 360.

According to an embodiment, the plate 340 may support at least a portion of the display panel 320. For example, the plate 340 may support the display panel 320 and provide rigidity to the display panel 320, by being disposed below a portion (e.g., the front portion 230 of FIG. 2A) of the display panel 320 including the plurality of sub-pixels. The plate 340 may include a metallic material.

The electronic device 200 according to an embodiment may include the bracket 350. For example, the bracket 350 may support components of the electronic device 200. For example, the printed circuit board 310 may be disposed on a side of the bracket 350 and may be supported by the bracket 350. The bracket 350 may include a metallic material. The bracket 350 may be configured to function as the ground of the electronic device 200. The electronic components of the electronic device 200 may be grounded by being electrically connected to the bracket 350.

Various electronic components associated with the display 160 may be included in the flexible printed circuit board 360. For example, the flexible printed circuit board 360 may include integrated circuitry such as circuitry for identifying a touch input from a user to the display 160 and circuitry for identifying a signal from an external electronic device such as a stylus pen. The flexible printed circuit board 360 may include a transmission line for transmitting a signal between the printed circuit board 310 and the display driver integrated circuitry 330. For reducing a noise component provided to electronic components included in the flexible printed circuit board 360, and for electrostatic discharge (ESD), it may be required to reinforce a ground of the display 160. For example, when the plate 340 supporting at least a portion of the display panel 320 is electrically connected to the bracket 350 that functions as the ground of the electronic device 200, the plate 340 may function as a portion of the ground. As the plate 340 included in the display 160 is grounded, the plate 340 may improve performance and durability of the display 160 by reducing the noise component on the display 160 and enhancing the ESD of the display 160.

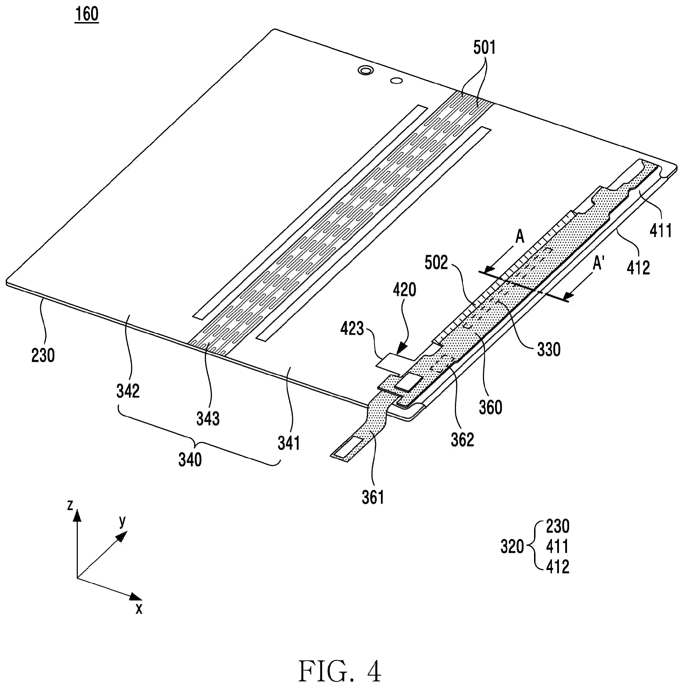

FIG. 4 is a rear view of a display according to an embodiment. FIG. 5 is a cross-sectional view of the display of FIG. 4 cut along line A-A'.

Referring to FIG. 4, a plate 340 may be exposed to a rear side of a display 160. The plate 340 may include a first supporting portion 341, a second supporting portion 342, and a bendable portion 343.

For example, the first supporting portion 341 may support a first portion (e.g., the first portion 231 of FIG. 2A) of a front portion 230 of a display panel 320 corresponding to a first housing part (e.g., the first housing part 210 of FIG. 2A). For example, the second supporting portion 342 may support a second portion (e.g., the second portion 232 of FIG. 2A) of the front portion 230 of the display panel 320 corresponding to a second housing part (e.g., the second housing part 220 of FIG. 2A). For example, the bendable portion 343 may support a third portion 233 of the front portion 230 of the display panel 320.

For example, the first supporting portion 341 and the second supporting portion 342 may be rigid to support the front portion 230 of the display panel 320. The bendable portion 343 may include a plurality of holes 501. The plurality of holes 501 included in the bendable portion 343 may provide flexibility to the bendable portion 343. When the third portion 233 of the front portion 230 is bent according to a rotation of the first housing part 210 and a rotation of the second housing part 220, the bendable portion 343 may be bent by increasing a width of the plurality of holes 501. The plurality of holes 501 may be referred to as a plurality of slits. The plate 340 may be referred to as a lattice structure or a lattice plate in terms of including the plurality of holes 501.

According to an embodiment, the display panel 320 may extend from a front side of the display 160 to a rear side of the display 160. For example, the display panel 320 may include a front portion 230, a rear portion 411, and a connection portion 412. Display driver integrated circuitry 330 may be electrically connected to the display panel 320 by being disposed on the rear portion 411 of the display panel 320. For example, the display driver integrated circuitry 330 may be electrically connected to the display panel 320 by being attached to a portion of the rear portion 411 of the display panel 320 through ACF 502.

According to an embodiment, a flexible printed circuit board 360 may be electrically connected to the display driver integrated circuitry 330. For example, the flexible printed circuit board 360 may be electrically connected to each of the rear portion 411 of the display panel 320 and a printed circuit board (e.g., the printed circuit board 310 of FIG. 3). For example, a portion 361 of the flexible printed circuit board 360 protruding outside the display panel 320 in FIG. 4 may be connected to the printed circuit board 310 by being bent. The display driver integrated circuitry 330 may be electrically connected to at least one processor (e.g., the processor 120 of FIG. 1) disposed on the printed circuit board 310 through the printed circuit board 310 and the flexible printed circuit board 360.

According to an embodiment, the display 160 may include a conductive adhesive 420. The conductive adhesive 420 may be configured to provide an electrical connection by including a conductive material. The conductive adhesive 420 may be configured to provide an electrical connection between the flexible printed circuit board 360 and the rear portion 411 of the display panel 320. For example, the flexible printed circuit board 360 may be electrically connected to the display panel 320 through the conductive adhesive 420. The conductive adhesive 420 may be contacted with each of another portion of the rear portion 411 of the display panel 320, which is different from the portion of the rear portion 411 of the display panel 320 to which the display driver integrated circuitry 330 is attached, and the flexible printed circuit boards 360. The conductive adhesive 420 may be an isotropically conductive adhesive or an anisotropically conductive adhesive.

According to an embodiment, the conductive adhesive 420 may be attached to the plate 340 of the display 160. For example, the conductive adhesive 420 may include a protruding portion 423 attached to the plate 340 by protruding from the flexible printed circuit board 360. The plate 340 may be electrically connected to the flexible printed circuit board 360 through the conductive adhesive 420.

Referring to FIG. 5, the display panel 320 may include the front portion 230, the rear portion 411, and the connection portion 412.

For example, the front portion 230 of the display panel 320 including a plurality of sub-pixels may be configured to display visual information. The plurality of sub-pixels included in the front portion 230 may be configured to emit light by being controlled by the display driver integrated circuitry 330. The front portion 230 of the display panel 320 may be visually recognized from the outside of an electronic device 200. The display 160 may include protection layers and a window attached to the front portion 230 to protect the front portion 230 of the display panel 320. The protection layers and the window may be substantially transparent.

For example, the rear portion 411 of the display panel 320 may be opposite to the front portion 230 of the display panel 320. The rear portion 411 of the display panel 320 may not be visually recognized from the outside the electronic device 200 by being disposed inside the electronic device 200. The connection portion 412 of the display panel 320 may extend from the front portion 230 of the display panel 320 to the rear portion 411 of the display panel 320. The connection portion 412 may be bent. The rear portion 411 of the display panel 320 may include a polyimide (PI) substrate. The PI substrate may include transmission lines for transmitting a signal provided from the display driver integrated circuitry 330 to the plurality of sub-pixels.

According to an embodiment, the display driver integrated circuitry 330 may be disposed on a portion of the rear portion 411 of the display panel 320. The display driver integrated circuitry 330 may be electrically connected to the rear portion 411 of the display panel 320. The signal provided from the display driver integrated circuitry 330 to the plurality of sub-pixels in the front portion 230 may be provided to the plurality of pixels from the display driver integrated circuitry 330 through the rear portion 411 and the connection portion 412. When the display driver integrated circuitry 330 is disposed on the rear portion 411 of the display panel 320 including the PI substrate, a disposition structure of the display driver integrated circuitry 330 may be referred to as a chip on plastic (COP) structure. The display driver integrated circuitry 330 may be electrically connected to the rear portion 411 of the display panel 320 through the ACF 502. Since the display driver integrated circuitry 330 is electrically connected to the display panel 320, the display driver integrated circuitry 330 may be electrically connected to the flexible printed circuit board 360 through the display panel 320.

According to an embodiment, the plate 340 may be disposed between the front portion 230 of the display panel 320 and the rear portion 411 of the display panel 320. The plate 340 may support the front portion 230 of the display panel 320. A spacer 601 may be interposed between the rear portion 411 of the display panel 320 and the plate 340. The spacer 601 may include an elastic material capable of absorbing impact. The spacer 601 may protect the display driver integrated circuitry 330 by absorbing the impact applied from the front side of the display 160.

According to an embodiment, the conductive adhesive 420 may include a first side 421 and a second side 422. For example, the first side 421 of the conductive adhesive 420 may be referred to as a side of the conductive adhesive 420 attached to the rear portion 411 of the display panel 320. The second side 422 of the conductive adhesive 420 may be referred to as a side of the conductive adhesive 420 opposite to the first side 421. The first side 421 of the conductive adhesive 420 may be attached to the rear portion 411 of the display panel 320, and the second side 422 of the conductive adhesive 420 may be attached to the flexible printed circuit board 360. For example, the first side 421 of the conductive adhesive 420 may be attached to the other portion of the rear portion 411 of the display panel 320, which is different from the portion of the rear portion 411 of the display panel 320 to which the display driver integrated circuitry 330 is attached. For example, the second side 422 of the conductive adhesive 420 may be attached to an open portion (e.g., an open portion 362 of FIG. 4) of the flexible printed circuit board 360 to which solder resist is omitted.

According to an embodiment, the flexible printed circuit board 360 may be electrically connected to the rear portion 411 of the display panel 320 and the printed circuit board 310, respectively, to electrically connect the display driver integrated circuitry 330 and the printed circuit board 310. For example, the flexible printed circuit board 360 may be electrically connected to the printed circuit board 310 by being physically connected to the printed circuit board 310. For example, the flexible printed circuit board 360 may be electrically connected to the rear portion 411 through the conductive adhesive 420.

According to an embodiment, the flexible printed circuit board 360 may include a portion electrically connected to the conductive adhesive 420 to electrically connect the flexible printed circuit board 360 to the conductive adhesive 420. The portion of the flexible printed circuit board 360 electrically connected to the conductive adhesive 420 may include the open portion 362 to which the solder resist is omitted.

According to an embodiment, the flexible printed circuit board 360 may include solder resist (or solder mask) forming an outermost layer of the flexible printed circuit board 360. The solder resist may physically protect conductive layers of the flexible printed circuit board 360 and reduce a solder bridge that may occur during a soldering process. The solder resist may reduce a short circuit by electrically insulating the conductive layers of the flexible printed circuit board 360. An electronic component (e.g., the display driver integrated circuitry 330) electrically connected to the flexible printed circuit board 360 may be connected to a conductive pad to which the solder resist is omitted (or removed). In the present disclosure, the open portion 362, which is a portion of the flexible printed circuit board 360 different from the conductive pad, may be referred to as a portion to which the solder resist is omitted (or removed) for an electrical connection between the conductive adhesive 420 and the flexible printed circuit board 360. The open portion 362 of the flexible printed circuit board 360 may be contacted with the second side 422 of the conductive adhesive 420. Since the solder resist is omitted in the open portion 362, the conductive layer of the flexible printed circuit board 360 may be exposed through the open portion 362. The conductive layer exposed through the open portion 362 may be electrically connected to the conductive adhesive 420 contacted with the open portion 362. The flexible printed circuit board 360 may be electrically connected to the conductive adhesive 420 through the open portion 362.

Referring back to FIG. 4, the conductive adhesive 420 electrically connected to the flexible printed circuit board 360 may be attached to the plate 340 of the display 160. For example, the conductive adhesive 420 may include the protruding portion 423, protruding from the flexible printed circuit board 360 and the rear portion 411 of the display panel 320, attached to the plate 340. The conductive adhesive 420 may be electrically connected to the plate 340 through the protruding portion 423 attached to the plate 340. In an example illustrated in FIG. 4, the conductive adhesive 420 may be contacted with both the rear portion 411 of the display panel 320 and the plate 340.

Through the above-described structure, the plate 340 may be electrically connected to a ground of the electronic device 200. According to an embodiment, the plate 340 may be grounded through the conductive adhesive 420 electrically connected to the plate 340, the flexible printed circuit board 360 electrically connected to the conductive adhesive 420 through the open portion 362, and the printed circuit board 310 electrically connected to the flexible printed circuit board 360.

As described above, the printed circuit board 310 may include a ground layer electrically connected to a bracket (e.g., the bracket 350 of FIG. 3) corresponding to the ground of the electronic device 200. Since the flexible printed circuit board 360 is connected to the printed circuit board 310, at least one of ground layers of the flexible printed circuit board 360 may be electrically connected to the ground layer of the printed circuit board 310. Since the flexible printed circuit board 360 is electrically connected to the conductive adhesive 420 through the open portion 362, the conductive adhesive 420 may be electrically connected to the bracket 350 through the flexible printed circuit board 360 and the printed circuit board 310 (e.g., the ground layer). Since the conductive adhesive 420 is electrically connected to the plate 340, the plate 340 may be electrically connected to the bracket 350 through the conductive adhesive 420, the flexible printed circuit board 360, and the printed circuit board 310 (e.g., the ground layer).

According to an embodiment, the display 160 may have a laminated structure in which the rear portion 411 of the display panel 320, the conductive adhesive 420, and the flexible printed circuit board 360 are vertically laminated. Through the laminated structure, a thickness of a battery may be secured. In the laminated structure, the rear portion 411 of the display panel 320 may be disposed between the plate 340 and the flexible printed circuit board 360. Since the rear portion 411 of the display panel 320 including the PI substrate has electrical insulation, the plate 340 may not be electrically connected to the flexible printed circuit board 360 in the laminated structure. In the laminated structure, since the plate 340 is not electrically connected to the bracket 350 corresponding to the ground of the electronic device 200, the plate 340 may not be grounded. In a case that the plate 340 is not grounded, quality of the display 160 may deteriorate due to interference and static electricity by an external signal provided to the flexible printed circuit board 360.

According to an embodiment, the plate 340 may be grounded through the conductive adhesive 420 contacted with both the plate 340 and the flexible printed circuit board 360. As described above, the conductive adhesive 420 may include the protruding portion 423, protruding from the flexible printed circuit board 360 and a rear side of the display panel 320, contacted with the plate 340. Since the plate 340 may be grounded through the conductive adhesive 420, the flexible printed circuit board 360, and the printed circuit board 310, a ground of the display 160 may be reinforced. For example, a noise component and/or static electricity of the flexible printed circuit board 360 may be reduced through the plate 340. By reducing the noise component and/or the static electricity, performance of the display 160 may be improved.

Hereinafter, the above-described laminated structure will be described in detail.

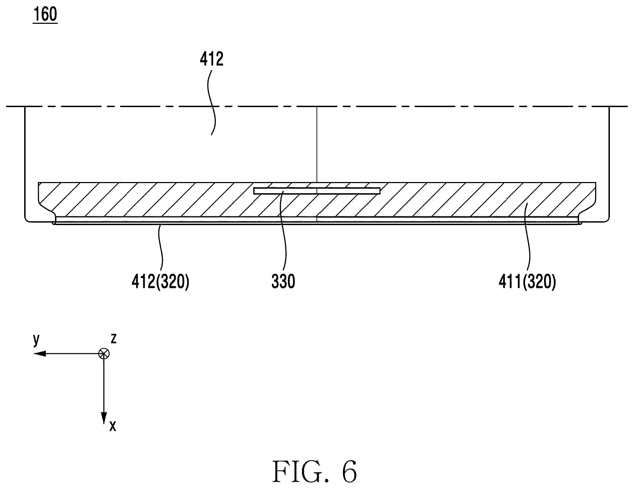

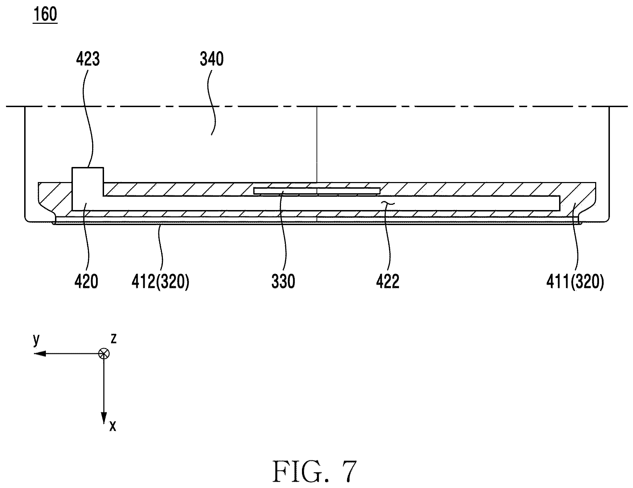

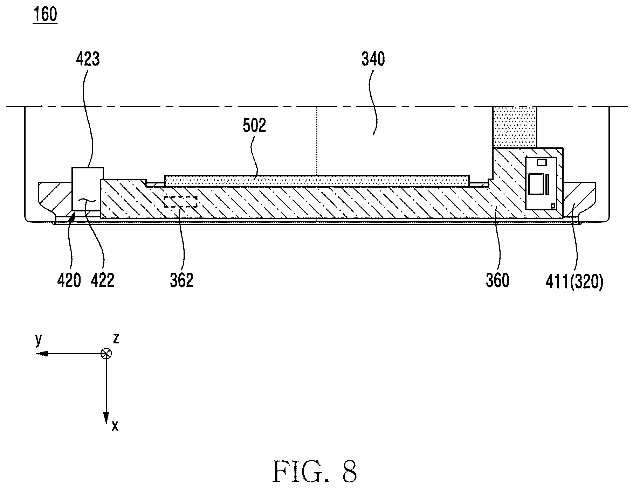

FIG. 6 illustrates a portion of a rear side of a display panel. FIG. 7 illustrates a state in which a conductive adhesive is attached to the display of FIG. 6. FIG. 8 illustrates a state in which a flexible printed circuit board is disposed on the display of FIG. 7.

Referring to FIG. 6, a rear portion 411 of a display panel 320 may overlap a plate 340. The plate 340 may be disposed between a front portion (e.g., the front portion 230 of FIG. 5) of the display panel 320 and the rear portion 411 of the display panel 320. Display driver integrated circuitry 330 may be electrically connected to the display panel 320 by being disposed on a portion of the rear portion 411 of the display panel 320. Connecting portion 412 connecting the front portion 230 of the display panel 320 and the rear portion 411 of the display panel 320 may be bent.

Referring to FIG. 7, a conductive adhesive 420 may be attached to the rear portion 411 of the display panel 320. For example, a first side (e.g., the first side 421 of FIG. 6) of the conductive adhesive 420 may be attached to another portion of the rear portion 411 of the display panel 320. The conductive adhesive 420 may include a protruding portion 423 attached to the plate 340 by protruding from the rear portion 411 of the display panel 320. Before a flexible printed circuit board (e.g., the flexible printed circuit board 360 of FIG. 8) is disposed, a second side 422 of the conductive adhesive 420 may be exposed.

Referring to FIG. 8, the flexible printed circuit board 360 may be attached to the second side 422 of the conductive adhesive 420. The flexible printed circuit board 360 may be electrically connected to display driver integrated circuitry (e.g., the display driver integrated circuitry 330 of FIG. 8) electrically connected to the display panel 320 through ACF 502. The flexible printed circuit board 360 may be connected to a printed circuit board (e.g., the printed circuit board 310 of FIG. 3). At least one processor (e.g., the processor 120 of FIG. 1) disposed on the printed circuit board 310 may be electrically connected to the display driver integrated circuitry 330 through the printed circuit board (e.g., the printed circuit board 310 of FIG. 3), the flexible printed circuit board 360, and the display panel 320 (e.g., the rear portion 411).

According to an embodiment, the flexible printed circuit board 360 may be electrically connected to the conductive adhesive 420. The flexible printed circuit board 360 may be electrically connected to the conductive adhesive 420 through an open portion 362 to which solder resist on a side of the flexible printed circuit board 360 facing the conductive adhesive 420 is omitted. The open portion 362 may be contacted with the conductive adhesive 420. The open portion 362 may face the second side 422 of the conductive adhesive 420.

According to an embodiment, the protruding portion 423 of the conductive adhesive 420 may be contacted with the plate 340 by protruding from the rear portion 411 of the display panel 320. As described above, the plate 340 may be grounded by being electrically connected to the conductive adhesive 420 through the protruding portion 423.

In the above-described example, the conductive adhesive 420 has been described to be contacted with both the rear portion 411 of the display panel 320 and the plate 340, but examples of the present disclosure are not limited thereto.

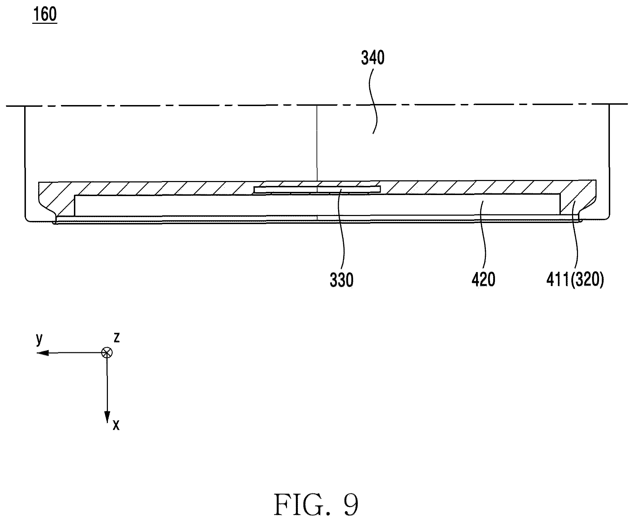

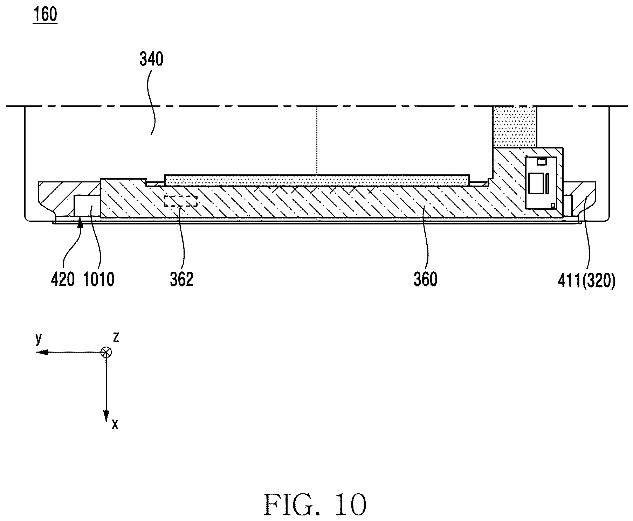

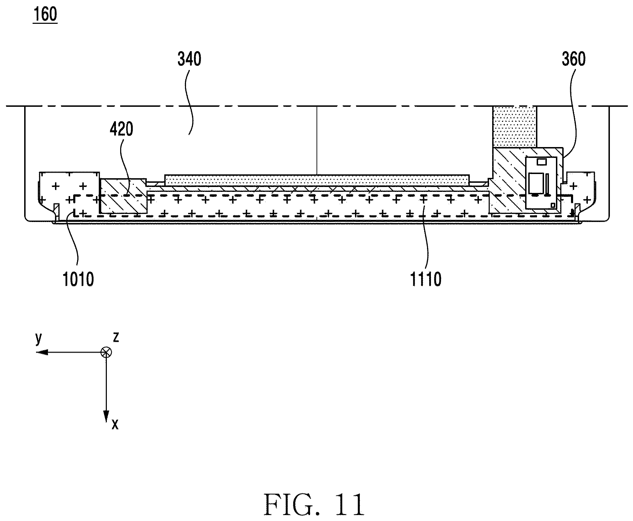

FIG. 9 illustrates a portion of a rear side of a display panel to which a conductive adhesive is attached. FIG. 10 illustrates a state in which a flexible printed circuit board is disposed on the display of FIG. 9. FIG. 11 illustrates a state in which a shielding sheet is disposed on the display of FIG. 10.

Referring to FIG. 9, display driver integrated circuitry 330 and a conductive adhesive 420 may be attached to a rear portion 411 of a display panel 320. As illustrated in FIG. 9, the conductive adhesive 420 may not be attached to a plate 340 but may only be attached to the rear portion 411 of the display panel 320.

Referring to FIG. 10, a flexible printed circuit board 360 may be attached to the conductive adhesive 420. The flexible printed circuit board 360 may be electrically connected to the conductive adhesive 420 through an open portion 362.

According to an embodiment, the conductive adhesive 420 may include a protruding portion 1010 protruding from the flexible printed circuit board 360 attached to the conductive adhesive 420. The protruding portion 1010 of the conductive adhesive 420 illustrated in FIG. 10 may be different from the protruding portion (e.g., the protruding portion 423 of FIG. 4) described above. For example, the protruding portion (e.g., the protruding portion 423 of FIG. 4) described above was contacted with both the rear portion 411 of the display panel 320 and the plate 340, but the protruding portion 1010 of FIG. 10 may be attached only to the rear portion 411 of the display panel 320 and may be separated from the plate 340. The protruding portion 1010 of the conductive adhesive 420 being separated from the plate 340 may be referred to as not contacting the plate 340. The protruding portion 1010 may be exposed to the outside of the flexible printed circuit board 360 by protruding from the flexible printed circuit board 360.

Referring to FIG. 11, a display 160 may include a shielding sheet 1110. The shielding sheet 1110 may at least partially cover the flexible printed circuit board 360 to protect the flexible printed circuit board 360 from electromagnetic interference such as an electromagnetic wave or a magnetic field. For example, the shielding sheet 1110 may be attached to at least a portion of the flexible printed circuit board 360. The shielding sheet 1110 may protect the flexible printed circuit board 360 by absorbing or reflecting the electromagnetic wave or the magnetic field. The shielding sheet 1110 may include a metal material or a conductive polymer material. The shielding sheet 1110 may be attached to the at least a portion of the flexible printed circuit board 360 to at least partially cover the flexible printed circuit board 360.

According to an embodiment, the shielding sheet 1110 may be attached to the conductive adhesive 420 and the plate 340, respectively. For example, the shielding sheet 1110 covering the at least a portion of the flexible printed circuit board 360 may be attached to the protruding portion 1010 of the conductive adhesive 420 protruding from the flexible printed circuit board 360, and may also be attached to the plate 340. The shielding sheet 1110 may have electrical conductivity. Since the shielding sheet 1110 has the electrical conductivity, the conductive adhesive 420 may be electrically connected to the shielding sheet 1110. Since the shielding sheet 1110 is attached to the plate 340, the conductive adhesive 420 may be electrically connected to the plate 340 through the shielding sheet 1110.

According to an embodiment, the plate 340 may be grounded through the shielding sheet 1110 attached to the plate 340, the conductive adhesive 420 electrically connected to the shielding sheet 1110, the flexible printed circuit board 360 electrically connected to the conductive adhesive 420 through the open portion 362, and a printed circuit board (e.g., the printed circuit board 310 of FIG. 3) electrically connected to the flexible printed circuit board 360. For example, since the plate 340 and the shielding sheet 1110 are contacted with each other, the plate 340 may be electrically connected to the shielding sheet 1110. The shielding sheet 1110 may be electrically connected to the conductive adhesive 420. The conductive adhesive 420 may be electrically connected to the flexible printed circuit board 360 through the open portion 362. The flexible printed circuit board 360 may be electrically connected to a ground layer of the printed circuit board 310 electrically connected to a bracket (e.g., the bracket 350 of FIG. 3) corresponding to a ground of an electronic device 200. The plate 340 may be electrically connected to the bracket 350 through the shielding sheet 1110, the conductive adhesive 420, the flexible printed circuit board 360, and the printed circuit board 310 (e.g., the ground layer).

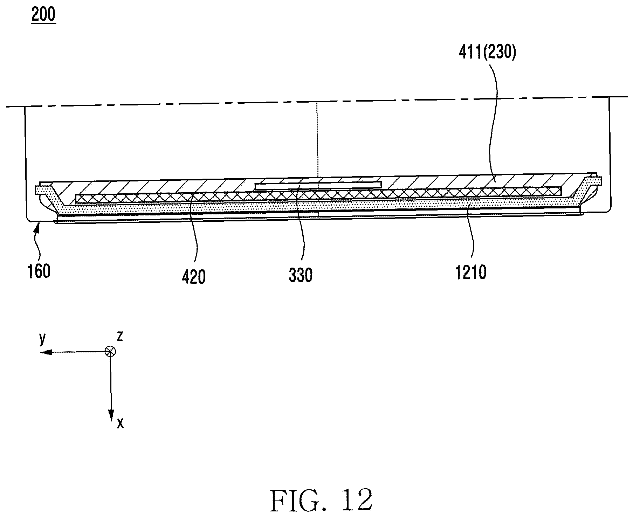

FIG. 12 illustrates a rear side of a display to which a waterproof tape is attached.

Referring to FIG. 12, an electronic device 200 may include a waterproof tape 1210. The waterproof tape 1210 may be disposed between a display 160 and a bracket (e.g., the bracket 350 of FIG. 3) to reduce an inflow of moisture between the display 160 and the bracket 350. For example, the bracket 350 may be referred to as the first bracket 215 of FIG. 2C. For example, the waterproof tape 1210 may form a waterproof space in a shape of a closed curve. The waterproof space may be surrounded by the waterproof tape 1210. Main components of the electronic device 200 may be positioned in the waterproof space surrounded by the waterproof tape 1210.

According to an embodiment, the waterproof tape 1210 may be disposed between the bracket 350 supporting the display 160, and the display 160. Since the waterproof tape 1210 is disposed between the display 160 and the bracket 350, a portion of the waterproof tape 1210 may be attached to a rear portion 411 of a display panel 320. As described above, display driver integrated circuitry 330 may be disposed on a portion of the display panel 320, and a conductive adhesive 420 may be disposed on another portion of the display panel 320. The waterproof tape 1210 attached to the rear portion 411 of the display panel 320 may be spaced apart from the display driver integrated circuitry 330 and the conductive adhesive 420.

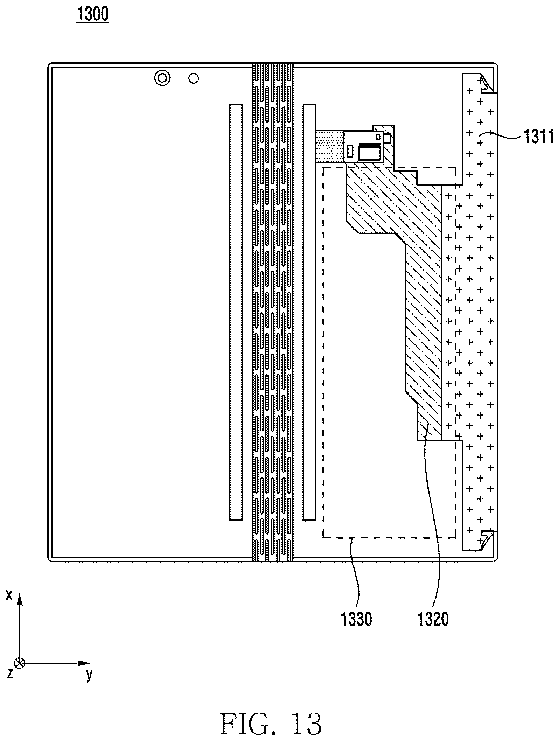

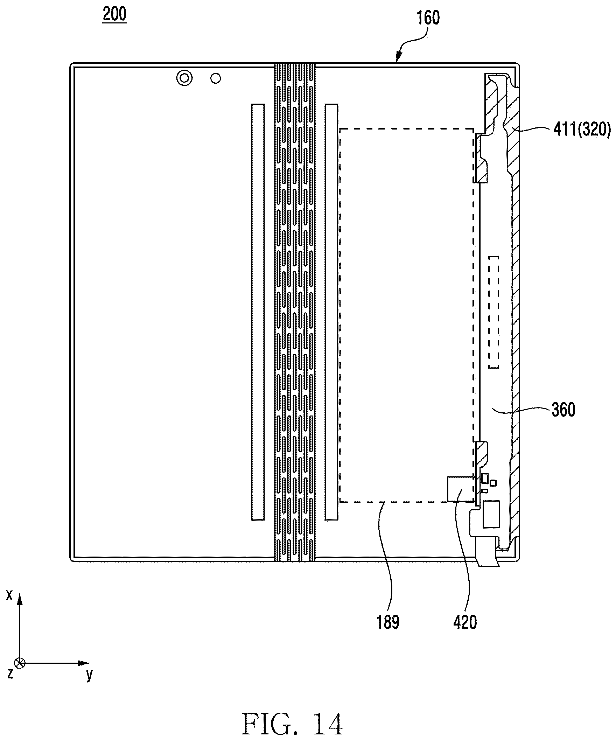

FIG. 13 illustrates an electronic device according to a comparative example. FIG. 14 illustrates an electronic device according to an embodiment.

In a case of an electronic device including a foldable housing (e.g., the foldable housing 201 of FIG. 2A), a space for a battery disposed inside the electronic device may be insufficient by a hinge assembly (e.g., the hinge assembly 250 of FIG. 2C). In a structure having a thin thickness, such as the foldable housing, a thickness of the electronic device may be limited. Due to a narrow space, a size of the battery included in the electronic device may be reduced. Since a charging capacity of the battery is substantially proportional to a volume of the battery, a reduction in the size of the battery may cause a reduction in the charging capacity of the battery.

Referring to FIG. 13, an electronic device 1300 according to a comparative example may include a structure in which a rear portion 1311 of a display panel and a flexible printed circuit board 1320 are connected substantially horizontally. For example, a portion of the flexible printed circuit board 1320 may be connected substantially horizontally to the rear portion 1311 of the display panel and may extend to a printed circuit board 310 on which at least one processor is disposed. As the flexible printed circuit board 1320 is connected substantially horizontally to the rear portion 1311 of the display panel, the flexible printed circuit board 1320 and the rear portion 1311 of the display panel may at least partially overlap a battery 1330 disposed inside the electronic device 1300. For example, a portion of the battery 1330 may be positioned below (e.g., a -z direction) the rear portion 1311 of the display panel and the flexible printed circuit board 1320.

In a case that the battery 1330 overlaps the flexible printed circuit board 1320 and/or the rear portion 1311 of the display panel, a thickness of the battery 1330 may be reduced in order to limit a thickness of the electronic device 1300. The reduction in the thickness of the battery 1330 may cause a reduction in a charging capacity of the battery 1330. In a case that the charging capacity of the battery 1330 is small, since charging of the battery 1330 is frequently required, use of the electronic device 200 may be inconvenient.

Referring to FIG. 14, the electronic device 200 according to an embodiment may include a display panel 320 and a flexible printed circuit board 360 that are substantially vertically laminated. As described above, a conductive adhesive 420 may be attached below (e.g., the -z direction) a rear portion 411 of the display panel 320, and the flexible printed circuit board 360 may be attached below the conductive adhesive 420. As the flexible printed circuit board 360 and the rear portion 411 of the display panel 320 are vertically laminated, a battery disposition space may be secured. For example, the battery may not overlap the rear portion 411 of the display panel 320 and the flexible printed circuit board 360. The battery may be spaced apart from the rear portion 411 of the display panel 320 and the flexible printed circuit board 360.

In a case of the electronic device 200 according to an embodiment, since a battery 189 does not overlap the rear portion 411 of the display panel 320 and the flexible printed circuit board 360, a thickness of the battery 189 may be secured. For example, in a case that the electronic device 200 includes the foldable housing 201, since the rear portion 411 of the display panel 320 and the flexible printed circuit board 360 may not be disposed in a space capable of accommodating the battery 189, the thickness of the battery 189 may be relatively thick. According to the increase in the thickness of the battery 189, a charging capacity of the battery 189 may increase. Since the electronic device 200 according to an embodiment may include the battery 189 having a relatively large charging capacity, usability of the electronic device 200 may be improved. As described above, the electronic device 200 according to an embodiment may improve performance of a display 160 by grounding a plate 340 of the display 160 while securing the charging capacity of the battery 189.

The above-described examples have been described as a structure of the display 160 applied to the electronic device 200 of a foldable structure, but examples of the present disclosure are not limited thereto. For example, the structure of the display 160, including the rear portion 411 of the display panel 320 and the flexible printed circuit board 360 that are vertically laminated, may be applied substantially the same to the electronic device 200 of the foldable structure as well as an electronic device 1500 of a bar structure to be described later. In examples to be described below, except for a bar-shape structure, the laminated structure of the display 160 may be substantially the same, and an overlapping description may be omitted or briefly described.

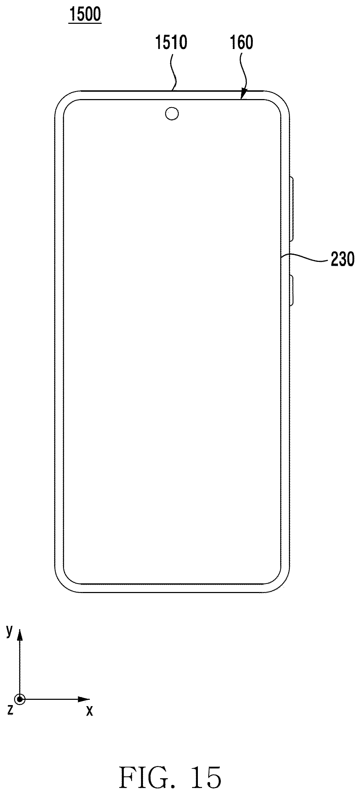

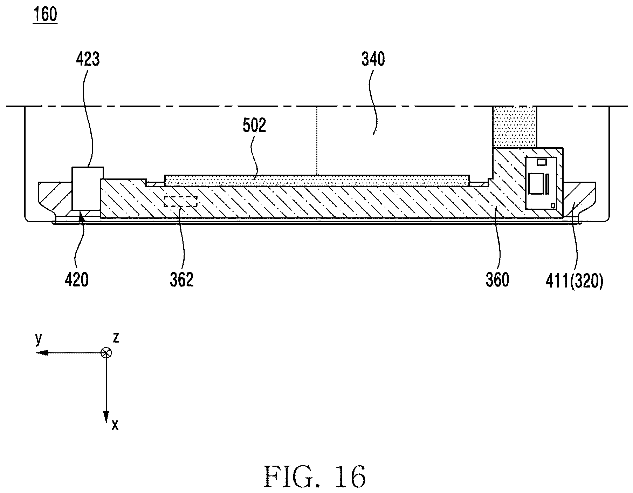

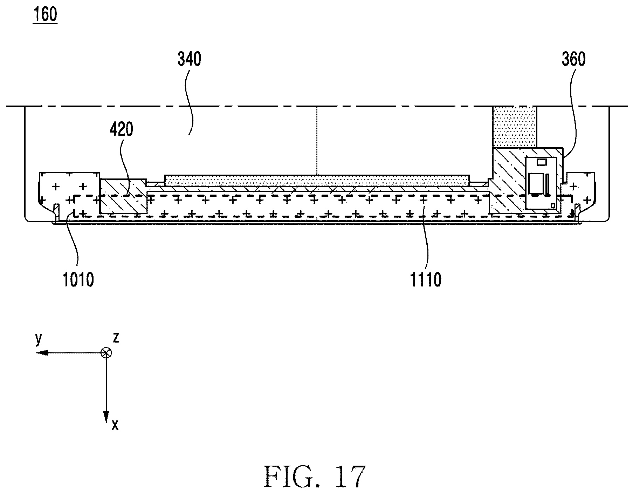

FIG. 15 illustrates an electronic device according to an embodiment. FIG. 16 illustrates an example of a rear side of the display of FIG. 15. FIG. 17 illustrates another example of a rear side of the display of FIG. 15.

Referring to FIG. 15, an electronic device 1500 may include a bar type device. The bar-type device may be referred to as a device having a housing 1510 in an approximately rectangular parallelepiped-shape. For example, the electronic device 1500 may include the housing 1510 in the rectangular parallelepiped-shape that is elongated in a longitudinal direction (e.g., a y-axis direction).

The electronic device 1500 according to this configuration may include a display 160. The display 160 may include a display panel (e.g., a display panel 320 of FIG. 16) including a plurality of sub-pixels displaying visual information. In order to protect the display panel 320, a substantially transparent window and protective layers may be disposed on a front side of the display panel 320. The display panel 320 may include a front portion (e.g., a front portion 230 of FIG. 16) including the plurality of sub-pixels, a rear portion (e.g., a rear portion 411 of FIG. 16) opposite the front portion 230, and a connection portion (e.g., a connection portion 412 of FIG. 16) connecting the front portion 230 and the rear portion 411. The rear portion 411 of the display panel 320 may not be visually recognized outside the electronic device 1500 by being disposed inside the housing 1510.

The structure of the rear portion 411 of the display panel 320 and a flexible printed circuit board 360 described above may be applied to the bar-type electronic device 1500 of FIG. 15 in substantially the same manner.

Referring to FIG. 16, a conductive adhesive 420 may be attached on the rear portion 411 of the display panel 320. The conductive adhesive 420 may include a protruding portion 423 attached to a plate 340 supporting the front portion (e.g., the front portion 230 of FIG. 15) of the display panel 320, by protruding from the rear portion 411 of the display panel 320. The flexible printed circuit board 360 may be attached to the conductive adhesive 420. The flexible printed circuit board 360 may be electrically connected to a ground layer of a printed circuit board 310 by being connected to the printed circuit board 310. Since the protruding portion 423 of the conductive adhesive 420 contacted the plate 340, the plate 340 may be electrically connected to the conductive adhesive 420. The flexible printed circuit board 360 may be electrically connected to the conductive adhesive 420 through an open portion (e.g., the open portion 362 of FIG. 4) to which solder resist is omitted. For example, a conductive layer of the flexible printed circuit board 360 may be contacted with the conductive adhesive 420 through the open portion 362. According to an embodiment, the plate 340 may be electrically connected to a ground of the electronic device 1500 through the conductive adhesive 420, the flexible printed circuit board 360, and the printed circuit board 310.

Referring to FIG. 17, the conductive adhesive 420 may not be attached to the plate 340, but may be attached only to the rear portion 411 of the display panel 320. A shielding sheet 1110 covering the flexible printed circuit board 360 may be contacted with each of the conductive adhesive 420 and the plate 340. The shielding sheet 1110 may have electrical conductivity. As the shielding sheet 1110 is contacted with the conductive adhesive 420 and the plate 340, respectively, the shielding sheet 1110 may be electrically connected to the conductive adhesive 420 and the plate 340. According to an embodiment, the plate 340 may be electrically connected to the ground of the electronic device 1500 through the shielding sheet, the conductive adhesive 420, the flexible printed circuit board 360, and the printed circuit board 310.

FIG. 18 is a block diagram of a display module according to various embodiments.

Referring to FIG. 18, a display module 160 (or a display) may include a display 1810 and a display driver IC (DDI) 1830 for controlling the display 1810. The DDI 1830 may include an interface module 1831, memory 1833 (e.g., buffer memory), an image processing module 1835, or a mapping module 1837. The DDI 1830 may receive, for example, video data, or video information including a video control signal corresponding to a command for controlling the video data, from another component of the electronic device 101 through the interface module 1831. For example, according to an embodiment, the video information may be received from a processor (e.g., the main processor 121 or the application processor of FIG. 1) or an auxiliary processor (e.g., the auxiliary processor 123 or the graphic processing device of FIG. 1) that operates independently of the main processor 121. The DDI 1830 may communicate with touch circuitry 1850 or a sensor module (e.g., the sensor module 176 of FIG. 1) through the interface module 1831. The DDI 1830 may store at least a portion of the received video information in the memory 1833 in a unit of a frame. The image processing module 1835 may, for example, perform pre-processing or post-processing (e.g., resolution, brightness, or size adjustment) on the at least a portion of the video data, based on a characteristic of the video data or a characteristic of the display 1810. The mapping module 1837 may generate a voltage value or a current value corresponding to the video data pre-processed or post-processed through the image processing module 135. According to an embodiment, the generation of the voltage value or the current value may be performed, for example, based at least in part on a property (e.g., an arrangement of pixels (e.g., an RGB strip or pentile structure), or a size of each of sub-pixels) of the pixels of the display 1810. For example, as at least a portion of the pixels of the display 1810 is driven based at least in part on the voltage value or the current value, visual information (e.g., text, image, or icon) corresponding to the video data may be displayed through the display 1810.

According to an embodiment, the display module 160 may further include the touch circuitry 1850. The touch circuitry 1850 may include a touch sensor 1851 and a touch sensor IC 1853 for controlling the touch sensor 1851. The touch sensor IC 1853 may control, for example, the touch sensor 1851 to detect a touch input or a hovering input to a specific position of the display 1810. For example, touch sensor IC 1853 may detect the touch input or the hovering input by measuring a change in a signal (e.g., a voltage, an amount of light, a resistance, or an amount of electric charge) for the specific position on the display 1810. The touch sensor IC 1853 may provide information (e.g., a position, an area, pressure, or time) on the detected touch input or hovering input to a processor 120. According to an embodiment, at least a portion (e.g., the touch sensor IC 1853) of the touch circuitry 1850 may be included as a portion of the display driver IC 1830, or as a portion of another component (e.g., the auxiliary processor 123) disposed outside the display module 160.

According to an embodiment, the display module 160 may further include at least one sensor (e.g., a fingerprint sensor, an iris sensor, a pressure sensor, or an illuminance sensor) of the sensor module 176, or control circuitry therefor. In this case, the at least one sensor or the control circuitry therefor may be embedded in a portion of the display module 160 (e.g., the display 1810 or the DDI 1830) or a portion of the touch circuitry 1850. For example, in a case that the sensor module 176 embedded in the display module 160 includes a biometric sensor (e.g., the fingerprint sensor), the biometric sensor may obtain biometric information (e.g., a fingerprint image) associated with the touch input through a partial area of the display 1810. For another example, in a case that the sensor module 176 embedded in the display module 160 includes a pressure sensor, the pressure sensor may obtain pressure information on the touch input through a partial or entire area of the display 1810. According to an embodiment, the touch sensor 1851 or the sensor module 176 may be disposed between pixels of a pixel layer of the display 1810, or above or below the pixel layer.

The technical problems to be achieved in this document are not limited to those described above, and other technical problems not mentioned herein will be clearly understood by those having ordinary knowledge in the art to which the present disclosure belongs.

An electronic device 101, 200, or 1500 is disclosed. The electronic device 101, 200, or 1500 may comprise a printed circuit board (PCB) 310 including a ground layer. The electronic device 101, 200, or 1500 may comprise a display 160 (or a display module). The display 150 may include a display panel 320 including a front portion 230 (or a front panel) including a plurality of sub pixels, a rear portion 411 (or a rear panel) opposite to the front portion 230 of the display panel 320, and a connection portion 412, extending from the front portion 230 of the display panel 320 to the rear portion 411 of the display panel 320, that is bent. The display 150 may include display driver integrated circuitry (DDI) 330 attached to a portion of the rear portion 411 of the display panel 320. The display 150 may include a plate 340, disposed between the front portion 230 of the display panel 320 and the rear portion 411 of the display panel 320, supporting the front portion 230 of the display panel 320. The display 150 may include a conductive adhesive 420, including a first side 421 attached to another portion of the rear portion 411 of the display panel 320 and a second side 422 opposite to the first side 421, electrically connected to the plate 340. The display 150 may include a flexible PCB (FPCB) 360, electrically connected to the conductive adhesive 420, electrically connected to the rear portion 411 of the display panel 320 and the PCB 310 to electrically connect the DDI 330 and the PCB 310.

According to an embodiment, the FPCB 360 may include a portion electrically connected to the conductive adhesive 420 to electrically connect the FPCB 360 to the conductive adhesive 420.

According to an embodiment, the portion of the FPCB 360 electrically connected to the conductive adhesive 420 may include an open portion 362, that solder resist is omitted, contacted with the second side 422 of the conductive adhesive 420.

According to an embodiment, the plate 340 may be grounded by the conductive adhesive 420 electrically connected to the plate 340, the FPCB 360 electrically connected to the conducive adhesive 420 through the open portion 362, and the PCB 310 electrically connected to the FPCB 360.

According to an embodiment, the conductive adhesive 420 may be contacted with both the rear portion 411 of the display panel 320 and the plate 340.

According to an embodiment, the conductive adhesive 420 may include a protruding portion 423, protruding from the FPCB 360 and the rear portion 411 of the display panel 320, contacted with the plate 340.

According to an embodiment, the display 160 may include a shielding sheet 1110, attached to at least a portion of the FPCB 360 to at least partially cover the FPCB 360, contacted with the conductive adhesive 420 and the plate 340, respectively. The conductive adhesive 420 may be electrically connected to the shielding sheet 1110 and may be electrically connected to the plate 340 via the shielding sheet.

According to an embodiment, the conductive adhesive 420 may include a protruding portion 1010, protruding from the FPCB 360, separated from the plate 340. The shielding sheet 1110 may be attached to the protruding portion 1010 of the conductive adhesive 420.

According to an embodiment, the plate 340 may be grounded by the shielding sheet 1110 attached to the plate 340, the conductive adhesive 420 electrically connected to the shielding sheet 1110, the FPCB 360 electrically connected to the conducive adhesive 420 through the open portion 362, and the PCB 310 electrically connected to the FPCB 360.

According to an embodiment, the electronic device 101, 200, or 1500 may further comprise a waterproof tape 1210 attached to the rear portion 411 of the display panel 320. The waterproof tape 1210 may be spaced apart from the DDI 330 and the conductive adhesive 420.

According to an embodiment, the electronic device 101, 200, or 1500 may further comprise a bracket 350, configured to function as a ground of the electronic device 101, 200, or 1500, supporting the PCB 310. The ground layer of the PCB 310 may be electrically connected to the bracket 350. The plate 340 may be electrically connected to the bracket 350 via the conductive adhesive 420, the FPCB 360, the ground layer of the PCB 310.

According to an embodiment, the plate 340, the rear portion 411 of the display panel 320, the conductive adhesive 420, and the FPCB 360 may at least partially overlap each other.

According to an embodiment, the electronic device 101, 200, or 1500 may further comprise a battery 189 spaced apart from the rear portion 411 of the display panel 320 and the FPCB 360.

According to an embodiment, the electronic device 101, 200, or 1500 may further comprise a foldable housing 201 including a first housing part 210 accommodating the PCB 310, and a second housing part 220 rotatably connected to the first housing part 210. The front portion 230 of the display panel 320 may include a first portion 231 corresponding to the first housing part 210, a second portion 232 corresponding to the second housing part 220, and a third portion 233, extending from the first portion 231 of the front portion 230 to the second portion 232 of the front portion 230, configured to at least partially be bent in accordance with a rotation of the first housing part 210 and a rotation of the second housing part 220.

According to an embodiment, the plate 340 may include a first supporting portion 341 supporting the first portion of the front portion 230 of the display panel 320, a second supporting portion 342 supporting the second portion of the front portion 230 of the display panel 320, and a bendable portion 343, extending from the first supporting portion 641 of the plate 340 to the second supporting portion 342 of the plate 340, including a plurality of holes 501.

An electronic device 101, 200, or 1500 is disclosed. The electronic device 101, 200, or 1500 may comprise a housing (e.g., the foldable housing 201, or the housing 1510) defining an exterior of the electronic device 101, 200, or 1500. The electronic device 101, 200, or 1500 may comprise a bracket 350, disposed in the housing, corresponding to a ground of the electronic device 101, 200, or 1500. The electronic device 101, 200, or 1500 may comprise a printed circuit board (PCB) 310, disposed in the housing, including a ground layer electrically connected to the bracket 350. The electronic device 101, 200, or 1500 may comprise a display 160. The display 160 may include a display panel 320 including a front portion 230 including a plurality of sub pixels, a rear portion 411, opposite to the front portion 230 of the display panel 320, disposed in the housing, and a connection portion 412, extending from the front portion 230 of the display panel 320 to the rear portion 411 of the display panel 320. The display 160 may include display driver integrated circuitry (DDI) 330 connected to the rear portion 411 of the display panel 320. The display 160 may include a plate 340, disposed between the front portion 230 of the display panel 320 and the rear portion 411 of the display panel 320, supporting the front portion 230 of the display panel 320. The display 160 may include a conductive adhesive 420, including a first side 421 attached to the rear portion 411 of the display panel 320 and a second side 422 opposite to the first side 421. The display 160 may include a flexible PCB (FPCB) 360, electrically connected to the conductive adhesive 420, electrically connected to the rear portion 411 of the display panel 320 and the PCB 310, respectively, to electrically connect the DDI 330 and the PCB 310. The display 160 may include a shielding sheet 1110, covering the FPCB 360, contacted with the second side 422 of the conductive adhesive 420 and the plate 340. The plate 340 may be grounded by the shielding sheet 1110 contacted with the plate 340, the conductive adhesive 420 contacted with the shielding sheet 1110, the FPCB 360 electrically connected to the second side 422 of the conductive adhesive 420, and the PCB 310 electrically connected to the FPCB 360.

According to an embodiment, the flexible printed circuit board 360 may be electrically connected to the conductive adhesive 420 through an open portion 362 contacted with the second side 422 of the conductive adhesive 420.

According to an embodiment, the conductive adhesive 420 may include a protruding portion 1010 protruding from the flexible printed circuit board 360. The shielding sheet 1110 may be attached to the protruding portion 1010 of the conductive adhesive 420.

According to an embodiment, the protruding portion 1010 of the conductive adhesive 420 may not be contacted with the plate 340.

According to an embodiment, the electronic device 101, 200, or 1500 may further comprise a battery 189 spaced apart from the rear portion 411 of the display panel 320 and the flexible printed circuit board 360.

The effects that can be obtained from the present disclosure are not limited to those described above, and any other effects not mentioned herein will be clearly understood by those having ordinary knowledge in the art to which the present disclosure belongs, from the following description.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a printed circuit board, PCB, including a ground layer;
a display including:
a display panel including:
a front portion including a plurality of sub pixels,
a rear portion opposite to the front portion of the display panel, and
a connection portion, extending from the front portion of the display panel to the rear portion of the display panel, that is bent,
display driver integrated circuitry, DDI, attached to a portion of the rear portion of the display panel,
a plate, disposed between the front portion of the display panel and the rear portion of the display panel, supporting the front portion of the display panel,
a conductive adhesive, including a first side attached to another portion of the rear portion of the display panel and a second side opposite to the first side, electrically connected to the plate, and
a flexible PCB, FPCB, electrically connected to the conductive adhesive, electrically connected to the rear portion of the display panel and the PCB to electrically connect the DDI and the PCB.

2. The electronic device of claim 1,
wherein the FPCB includes a portion electrically connected to the conductive adhesive to electrically connect the FPCB to the conductive adhesive.

3. The electronic device of claim 2,
wherein the portion of the FPCB electrically connected to the conductive adhesive includes an open portion being free of solder resist contacted with the second side of the conductive adhesive.

4. The electronic device of claim 1,
wherein the plate is grounded by:
the conductive adhesive electrically connected to the plate,
the FPCB electrically connected to the conducive adhesive through the open portion, and
the PCB electrically connected to the FPCB.

5. The electronic device of any one of the preceding claims,
wherein the conductive adhesive is contacted with both the rear portion of the display panel and the plate.

6. The electronic device of any one of the preceding claims,
wherein the conductive adhesive includes a protruding portion, protruding from the FPCB and the rear portion of the display panel, contacted with the plate.

7. The electronic device of any one of the preceding claims,
wherein the display includes a shielding sheet, attached to at least a portion of the FPCB to at least partially cover the FPCB, contacted with the conductive adhesive and the plate, respectively, and
wherein the conductive adhesive is electrically connected to the shielding sheet and is electrically connected to the plate via the shielding sheet.

8. The electronic device of claim 7,
wherein the conductive adhesive includes a protruding portion, protruding from the FPCB, separated from the plate, and
wherein the shielding sheet is attached to the protruding portion of the conductive adhesive.

9. The electronic device of claim 7 or 8,
wherein the plate is grounded by:
the shielding sheet attached to the plate,
the conductive adhesive electrically connected to the shielding sheet,
the FPCB electrically connected to the conducive adhesive, and
the PCB electrically connected to the FPCB.

10. The electronic device of any one of the preceding claims, further comprising a waterproof tape attached to the rear portion of the display panel, and
wherein the waterproof tape is spaced apart from the DDI and the conductive adhesive.

11. The electronic device of any one of the preceding claims, further comprising a bracket, configured to function as a ground of the electronic device, supporting the PCB,
wherein the ground layer of the PCB is electrically connected to the bracket, and
wherein the plate is electrically connected to the bracket via the conductive adhesive, the FPCB, the ground layer of the PCB.

12. The electronic device of any one of the preceding claims,
wherein the plate, the rear portion of the display panel, the conductive adhesive, and the FPCB at least partially overlaps each other.

13. The electronic device of any one of the preceding claims, further comprising a battery spaced apart from the rear portion of the display panel and the FPCB.

14. The electronic device of any one of the preceding claims, further comprising a foldable housing including:
a first housing part accommodating the PCB, and
a second housing part rotatably connected to the first housing part,
wherein the front portion of the display panel includes:
a first portion corresponding to the first housing part,
a second portion corresponding to the second housing part, and
a third portion, extending from the first portion of the front portion to the second portion of the front portion, configured to at least partially be bent in accordance with a rotation of the first housing part and a rotation of the second housing part.

15. The electronic device of claim 14,
wherein the plate includes:
a first supporting portion supporting the first portion of the front portion of the display panel,
a second supporting portion supporting the second portion of the front portion of the display panel, and
a bendable portion, extending from the first supporting portion of the plate to the second supporting portion of the plate, including a plurality of holes.
